# EUROPÄISCHE PATENTSCHRIFT

(11) **EP 1 208 604 B1**
(45) Veröffentlichungstag und Bekanntmachung des Hinweises auf die Patenterteilung: **25.10.2006**
(21) Anmeldenummer: 00958119.0
(22) Anmeldetag: 08.07.2000
(51) Int. Cl.: H01L 29/861, H01L 21/329

(54) **VERFAHREN ZUR HERSTELLUNG EINER HALBLEITERDIODE**
METHOD FOR PRODUCING A SEMICONDUCTOR DIODE
PROCEDE DE PRODUCTION D'UNE DIODE A SEMI-CONDUCTEUR

(30) Priorität: 12.08.1999 DE 19938209
(43) Veröffentlichungstag der Anmeldung: 29.05.2002
(73) Patentinhaber: ROBERT BOSCH GMBH, 70442 Stuttgart (DE)
(72) Erfinder: GOEBEL, Herbert, D-72766 Reutlingen (DE); GOEBEL, Vesna, D-72766 Reutlingen (DE)
(86) Internationale Anmeldenummer: PCT/DE2000/002235
(87) Internationale Veröffentlichungsnummer: WO 2001/013434

(56) Entgegenhaltungen:
- DE-A- 4 320 780
- DE-A- 19 857 243

## Beschreibung

### Stand der Technik

Die Erfindung geht aus von einem Verfahren zur Herstellung der Halbleiteranordnung nach der Gattung des unabhängigen Anspruchs. Es ist schon aus der deutschen Patentanmeldung DE-A-4320780 eine Halbleiterdiode mit einer ersten aus zwei Teilschichten bestehenden Schicht und einer zweiten Schicht, bei der die zweite Schicht auf der ersten Teilschicht angeordnet ist, bekannt.

### Vorteile der Erfindung

Das erfindungsgemäße Verfahren zur Herstellung der Halbleiteranordnung mit den kennzeichnenden Merkmalen des unabhängigen Anspruchs hat demgegenüber den Vorteil, in einer für die Großserienfertigung günstigen Weise ohne großen technischen Mehraufwand bei gleichbleibender Chipfläche Dioden mit erhöhter maximal zulässiger Leistung und geringerer Flußspannung bereitzustellen. Dies ist insbesondere von Vorteil, wenn eine maximal vorgegebene Chipflächengröße nicht überschritten werden soll, sowohl um Chipfläche zu sparen, als auch, wenn die Größe verwendeter Kontaktsockel zur Kontaktierung der Halbleiteranordnung eine bestimmte Größe nicht überschreiten soll, um eine erhöhte Stromtragfähigkeit der insbesondere bei einer Kfz-Gleichrichteranordnung verwendeten Dioden nicht mit einem größeren Volumen der Gesamtgleichrichteranordnung erkaufen zu müssen. Die Erfindung zeigt somit einen technisch relativ leicht realisierbaren Weg, wie bei gleichbleibender Silizium-Chipfläche die zulässige Strombelastung gesteigert bzw. die thermische Belastung des Silizium-Chips reduziert werden kann. Gleichzeitig wird dabei eine Verringerung der Flußspannung erreicht. Insbesondere vorteilhaft erweist sich der Effekt zusätzlicher Sägerillen dadurch, daß später beim Lötprozeß von Sockel und Kopfdraht an den Diodenchip die Rillen zu einem besseren, lunkerfreien Löten führen (Kapillarwirkung) sowie die mit Lot gefüllten Rillen zu einer weiteren, besseren Kühlung des Chips führen, die in die Tiefe des Siliziumkörpers reicht, also zu einer intensiveren thermischen Ankopplung des Chips an die Wärmesenke.

Weitere Vorteile ergeben sich durch die in den abhängigen Ansprüchen aufgeführten Weiterbildungen und Verbesserungen des im unabhängigen Anspruch angegebenen Verfahrens.

### Zeichnung

Ausführungsbeispiele der Erfindung sind in der Zeichnung dargestellt und in der nachfolgenden Beschreibung näher erläutert.

Es zeigen Figur la eine Diode in Querschnittsseitenansicht, Figur 1b eine Diode in Draufsicht, Figur 2 einen Verfahrensschritt sowie Figur 3 und 4 weitere Verfahrensschritte.

### Beschreibung der Ausführungsbeispiele

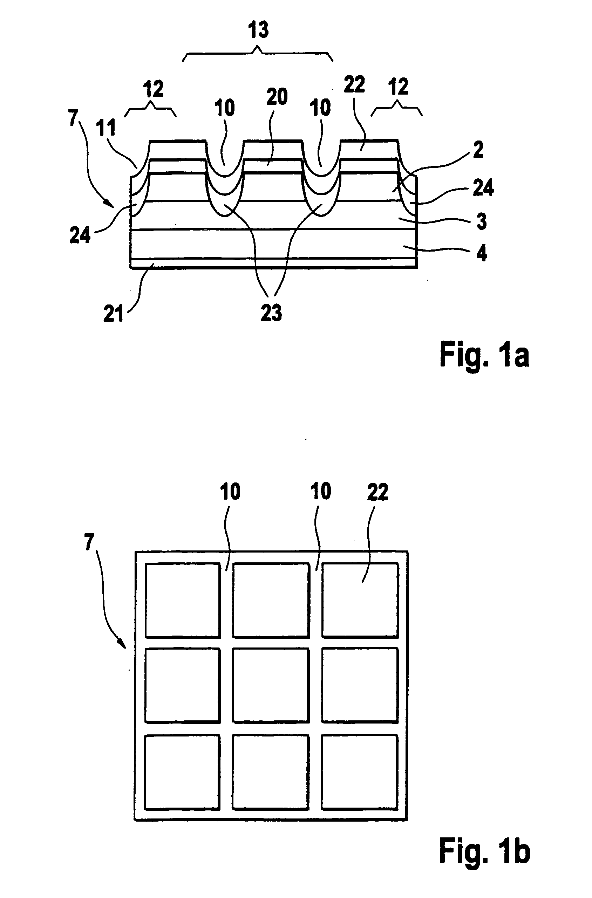

Figur la zeigt, als Querschnittsseitenansicht dargestellt, einen als Diode ausgebildeten Halbleiterchip 7. Der Chip 7 weist eine erste Halbleiterschicht (2, 3, 4) auf, die aus einer ersten Teilschicht 2, einer zweiten Teilschicht 3 und einer dritten Teilschicht 4 besteht. Die Dotierung der n-dotierten Teilschicht 2 liegt in der Größenordnung von 10¹⁸ cm⁻³. Die Teilschicht 3 ist mit einer Konzentration von ca. 10¹⁴ cm⁻³ n-dotiert, und die Teilschicht 4 ist mit einer n-Konzentration von ca. 10²⁰ cm⁻³. In die Teilschicht 2 sind zwei Gräben 10 eingebracht, die bis in die Teilschicht 3 hineinreichen. Diese Gräben 10 befinden sich im Innenbereich 13 des Chips 7. Die Randbereiche 12 des Chips weisen eine Abschrägung 11 auf, die ebenfalls wie die Gräben 10 bis in die Teilschicht 3 hineinreicht. Auf die erste Teilschicht 2 sowie in den Gräben 10 als auch in der Abschrägung 11 ist eine zweite Schicht 20 aufgebracht, deren Bereiche in den Gräben 10 bzw. in den Abschrägungen 11 als Fortsetzungsbereiche 23 bzw. weitere Fortsetzungsbereiche 24 der zweiten Schicht 20 bezeichnet werden. Die zweite Schicht 20 ist p-dotierten und weist eine Dotierung in der Größenordnung von 10²⁰ cm⁻³ auf. Die mit der Schicht 20 bedeckte Oberseite des Wafers sowie die Unterseite des Wafers, die durch die Schicht 4 gebildet wird, sind mit Metallisierungen 22 bzw. 21 versehen. Figur 1b zeigt dasselbe Bauelement in Draufsicht. Der Chip 7 ist oben mit der Metallisierung 22 bedeckt. Diese Metallisierung 22 weist in Folge der eingebrachten Gräben 10 eine Struktur auf, die durch entsprechende Vertiefungen charakterisiert ist.

Der pn-Übergangsbereich der Diode wird gebildet durch die p-dotierte Schicht 20 und die n-dotierten Schichten 2 bzw. 3. In Folge der eingebrachten Gräben 10 ist durch die Fortsetzungsbereiche 23 im Inneren 13 des Chips 7 ein pn-Übergang mit der zweiten Teilschicht 3 gebildet. Diese Bereiche führen zu einer Erniedrigung der Flußspannung der Diode mit der Metallisierung 22 als Anode und der Metallisierung 21 als Kathode. Durch vier Rillen im Inneren des Chips 7 (vgl. Figur 1b) läßt sich eine Steigerung der elektrischen Belastung gegenüber einer identisch aufgebauten Diode ohne Rillen im Inneren um über 12 % erreichen, d.h. eine beispielsweise mit 65 A belastbare Diode läßt sich zu einer Diode mit einer maximalen Belastung von 75 A machen. Aus einer 80 A-Diode wird eine 90 A-Diode. Die Flußspannung kann um ca. 60 mV (gemessen bei 100 A Belastung) gesenkt werden. Die vier zusätzlichen Rillen bzw. Gräben im Inneren des Chips 7 führen darüber hinaus zu einem besseren, lunkerfreien Löten des Chips, d.h. einem verbesserten Anbringen von Sockel und Kopfdraht an den Diodenchip. Darüber hinaus ist durch bei diesem Lötprozeß mit Lot gefüllten Rillen (in der Abbildung nicht dargestellt) eine verbesserte Kühlung des Chips gewährleistet, da durch das sich in den Rillen befindende Lot, das die Rillen dann vollständig ausfüllt, eine intensive thermische Ankopplung des Chips an einem als Wärmesenke dienenden Metallsockel gegeben ist.

Figur 1b stellt den Spezialfall eines quadratischen Chips 7 dar. Aber nicht nur Quadrate, sondern auch andere, durch gerade Kanten begrenzte Flächen (z.B. Sechsecke oder Achtecke) sind möglich mit entsprechend zu den Kanten parallelen, innenliegenden Zusatzrillen.

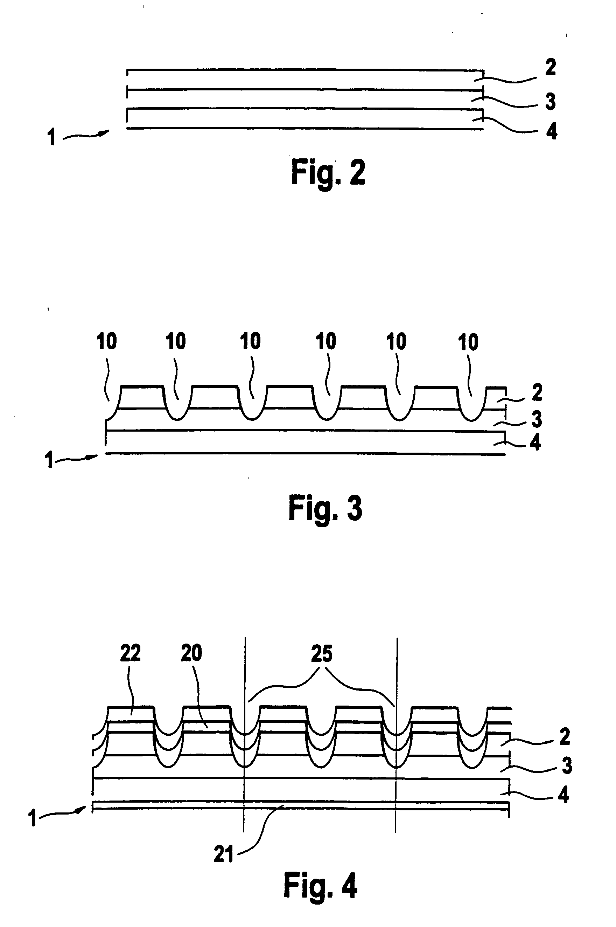

Figur 2 zeigt einen Halbleiterwafer mit einer ersten Teilschicht 2, einer zweiten Teilschicht 3 und einer dritten Teilschicht 4. Alle drei Teilschichten sind n-dotiert. Ausgangspunkt zur Herstellung dieser Schichtenfolge ist ein schwach n-dotierter Wafer, dessen Dotierstoffkonzentration der Dotierstoffkonzentration der Teilschicht 3 entspricht. Durch eine Foliendiffusion wird dann auf die Oberseite und auf die Unterseite n-Dotierstoff, beispielsweise Phosphor, eingebracht und eindiffundiert. Auf der Oberseite wird so eine Schicht gebildet, deren Dotierstoffkonzentration der Teilschicht 2 entspricht, und auf der Unterseite eine Schicht gebildet, deren Dotierstoffkonzentration der Teilschicht 4 entspricht. Die Dotierstoffkonzentration der Schichten wird dabei durch die Dotierstoffkonzentration der Folien bestimmt.

Die Herstellung einer solchen Schichtenfolge ist bereits aus der deutschen Patentanmeldung DE-A-4320780 bekannt. Als Alternative dazu kann diese Schichtenfolge auch unter Einsatz von Neutralfolien hergestellt werden, wie in der deutschen Patentanmeldung DE-A-19857243 beschrieben.

Figur 3 zeigt einen weiteren Schritt des erfindungsgemäßen Herstellungsverfahrens. Dabei werden in den Halbleiternwafer Gräben 10 eingebracht, die die Teilschicht 2 in Teilbereiche unterteilt, wobei die Gräben 10 bis zur Teilschicht 3 hindurchreichen. Das Einbringen der Gräben 10 kann beispielsweise durch Sägen oder durch Ätzen erfolgen. Der Abstand der Gräben 10 ist dabei so bemessen, daß der Wafer nachfolgend entlang der Gräben in einzelne Chips zerteilt werden kann, wobei jeder Chip nach der Zerteilung mindestens noch einen Graben 10 in seinem Inneren aufweist. Vor der weiteren Verarbeitung wird jedoch zunächst die Wafer-Oberfläche gesäubert, um eventuell verbliebene Partikel von der Oberfläche zu entfernen.

Im Vergleich zur deutschen Patentanmeldung DE-A-4320780 wird der Abstand der Sägelinien beim Einsägen halbiert (um zwei zusätzliche Rillen pro Chip zu erhalten) bzw. auf ein Drittel verringert (um vier zusätzliche Rillen pro Chip zu erhalten). Der Abstand der Rillen beträgt dabei typisch 1 - 3 mm. Dabei ist kein zusätzlicher Prozeßschritt notwendig, da ja das Einsägen zum Anlegen des Chiprandes, wie aus der DE-A-4320780 bekannt, sowieso durchgeführt wird. Es muß lediglich ein etwas geringerer Linienabstand beim Einsägen eingestellt werden. Dadurch ändert sich die Prozeßzeit dieses Sägeschritts nicht wesentlich, da das Wafer-Handling, das Justieren und das an das Einsägen anschließende Reinigen mit deonisiertem Wasser in der automatischen Sägeeinrichtung ohnehin durchgeführt werden.

Nach dem Einbringen der Gräben 10 wird in die Oberseite ein p-Dotierstoff, beispielsweise Bor, eingebracht. Gleichzeitig kann, sofern dies vorteilhaft erscheint, die Dotierstoffkonzentration der unteren Schicht 4 erhöht werden. Das Einbringen des p-Dotierstoffes erfolgt wieder durch Foliendiffusion. Bei diesem Diffusionsschritt werden eventuelle Schäden, die in der unmittelbaren Nähe der Gräben 10 im Siliziumeinkristall vorhanden sind, ausgeheilt. Durch die p-Diffussion wird die obere Schicht des Silizium-Wafers in ein p-leitendes Gebiet umgewandelt. Die Dicke dieser p-Schicht ist dabei überall auf der Oberfläche, insbesondere auch in den Gräben, annähernd gleich. Die resultierende p-leitende Schicht ist in Figur 4 mit Bezugszeichen 20 dargestellt. Im Anschluß an das Aufbringen der Schicht 20 und das eventuell durchgeführte Verstärken der Dotierung der Teilschicht 4 wird eine beidseitige Metallisierung des Wafers durchgeführt, so daß sowohl die p-leitende Schicht 20 mit einer Metallisierung 22 als auch die n-dotierte dritte Teilschicht 4 mit einer Metallisierung 21 versehen sind. In einem weiteren Schritt wird der Wafer entlang der Zerteilungslinien 25 in eine Vielzahl einzelner Dioden zerteilt, so daß Einzelchips 7 gebildet werden, deren Aufbau in Figur 1a und 1b beschrieben ist. Vor dem Zersägen entlang der Zerteilungslinien 25 wird dabei der Wafer auf der Seite mit der Metallisierung 21, also der Unterseite, auf eine Sägefolie aufgeklebt, damit die einzelnen Chips nicht unkontrolliert wegfliegen bzw. beschädigt werden.

Die Breite der Sägelinien beim Einsägen beträgt ca. 40 bis 150 µm, die Chipkantenlängen liegen im Bereich von ca. 5 mm. Bezogen auf die Chipfläche machen die Flächen der zusätzlichen Sägerillen im Inneren der einzelnen Chips lediglich einige Prozent aus. Das erfindungsgemäße Verfahren kann selbstverständlich auch zur Herstellung von Dioden mit vertauschten Dotierungen eingesetzt werden, also beispielsweise bei Dioden, bei denen von einem p-dotieren Wafer statt eines n-dotierten Wafer ausgegangen wird.

## Patentansprüche

1. Verfahren zur Herstellung einer Halbleiteranordnung, bei dem in einem ersten Schritt ein Halbleiterwafer (1) mit einer ersten, mindestens zwei Teilschichten aufweisenden Schicht (2, 3) bereitgestellt wird, wobei die erste Teilschicht (2) auf der zweiten Teilschicht (3) aufgebracht ist und beide Teilschichten einen ersten Leitfähigkeitstyp aufweisen, wobei die erste Teilschicht eine erste Dotierstoffkonzentration und die zweite Teilschicht eine zweite Dotierstoffkonzentration aufweist, wobei die zweite Dotierstoffkonzentration kleiner ist als die erste,
in einem weiteren Schritt Gräben (10) in die erste Schicht eingebracht werden, die durch die erste Teilschicht hindurch bis in die zweite Teilschicht reichen,
in einem weiteren Schritt Dotierstoffe des entgegengesetzten Leitfähigkeitstyps in die Oberseite des Wafers eingebracht werden, um den Leitfähigkeitstyp eines Teils der ersten Teilschicht und eines Teils der zweiten Teilschicht zur Ausbildung einer zweiten Schicht (20) zu verändern,
in einem weiteren Schritt Metallisierungen (21, 22) auf der Ober- und der Unterseite des Wafers aufgebracht werden, **dadurch gekennzeichnet, daß** in einem weiteren.Schritt der Wafer entlang der Gräben derart in einzelne Chips zerteilt wird, daß jeder Chip in seinem Innern mindestens einen Graben (10) aufweist.

2. Verfahren nach Anspruch 1, **dadurch gekennzeichnet, daß** das Einbringen der Gräben durch Sägen erfolgt.

3. Verfahren nach Anspruch 1, **dadurch gekennzeichnet, daß** das Einbringen der Gräben durch Ätzen erfolgt.

## Claims

1. Method for producing a semiconductor arrangement, in which
a first step involves providing a semiconductor wafer (1) having a first layer (2, 3), which has at least two partial layers, the first partial layer (2) being applied on the second partial layer (3) and both partial layers having a first conductivity type, the first partial layer having a first dopant concentration and the second partial layer having a second dopant concentration, the second dopant concentration being less than the first,
a further step involves introducing trenches (10) into the first layer, which trenches reach through the first partial layer right into the second partial layer,
a further step involves introducing dopants of the opposite conductivity type into the top side of the wafer in order to alter the conductivity type of a part of the first partial layer and a part of the second partial layer for the purpose of forming a second layer (20),
a further step involves applying metallizations (21, 22) on the top side and the underside of the wafer, **characterized in that** a further step involves dividing the wafer along the trenches into individual chips in such a way that each chip has at least one trench (10) internally.

2. Method according to Claim 1, **characterized in that** the trenches are introduced by sawing.

3. Method according to Claim 1, **characterized in that** the trenches are introduced by etching.

## Revendications

1. Procédé de fabrication d'un dispositif à semi-conducteurs, selon lequel
dans une première étape est mise à disposition une plaquette à semi-conducteurs (1) présentant une première couche (2, 3) composée d'au moins deux couches partielles, la première couche partielle (2) étant déposée sur la deuxième couche partielle (3) et les deux couches partielles présentant un premier type de conductibilité, la première couche partielle présentant une première concentration d'agent de dopage et la deuxième couche partielle une deuxième concentration d'agent de dopage, la deuxième concentration d'agent de dopage étant plus faible que la première,
dans une autre étape des canaux (10) sont formés dans la première couche et s'étendent à travers la première couche partielle jusque dans la deuxième couche partielle,
dans une autre étape des agents de dopage de conductibilité opposé sont introduits dans la face supérieure de la plaquette pour modifier le type de conductibilité d'une partie de la première couche partielle et d'une partie de la deuxième couche partielle pour former une deuxième couche (20),
dans une autre étape des métallisations (21, 22) sont appliquées sur les faces supérieure et inférieure de la plaquette,
**caractérisé en ce que**
dans une autre étape la plaquette est morcelée le long des canaux en puces distinctes de sorte que l'intérieur de chaque puce présente au moins un canal (10).

2. Procédé selon la revendication 1,
**caractérisé en ce que**
les canaux sont formés par sciage.

3. Procédé selon la revendication 1,
**caractérisé en ce que**
les canaux sont formés par gravure.
